# EUROPÄISCHE PATENTSCHRIFT

(11) **EP 2 800 125 B1**
(45) Veröffentlichungstag und Bekanntmachung des Hinweises auf die Patenterteilung: **24.10.2018**
(21) Anmeldenummer: 14167024.0
(22) Anmeldetag: 05.05.2014
(51) Int. Cl.: H01L 21/304, H01L 21/02

(54) **Verfahren zum Herstellen von Wafern mittels einer vordefinierten Spannungsverteilung**
Method for producing wafers with predetermined stress distribution
Procédé de production de plaquettes à l'aide d'une distribution de tension prédéfinie

(30) Priorität: 03.05.2013 DE 102013007673
(43) Veröffentlichungstag der Anmeldung: 05.11.2014
(73) Patentinhaber: Siltectra GmbH, 01099 Dresden (DE)
(72) Erfinder: Lichtensteiger, Lukas, 8037 Zürich (CH)
(74) Vertreter: Ascherl, Andreas

(56) Entgegenhaltungen:
- EP-A2- 1 858 087
- US-A1- 2012 322 227
- FREDERIC DROSS ET AL: "Crystalline thin-foil silicon solar cells: where crystalline quality meets thin-film processing", PROGRESS IN PHOTOVOLTAICS: RESEARCH AND APPLICATIONS, Bd. 20, Nr. 6, 1. September 2012 (2012-09-01), Seiten 770-784, XP055091882, ISSN: 1062-7995, DOI: 10.1002/pip.1238
- STEPHEN W BEDELL ET AL: "Kerf-Less Removal of Si, Ge, and III V Layers by Controlled Spalling to Enable Low-Cost PV Technologies", IEEE JOURNAL OF PHOTOVOLTAICS, I E E E, US, Bd. 2, Nr. 2, 1. April 2012 (2012-04-01), Seiten 141-147, XP011434299, ISSN: 2156-3381, DOI: 10.1109/JPHOTOV.2012.2184267

## Beschreibung

Die vorliegende Erfindung bezieht sich auf ein Verfahren zur Herstellung von Festkörperschichten, auf eine Vorrichtung zum Herstellen von Festkörperschichten, auf eine Trägereinheit zum Aufnehmen mindestens einer Festkörperschicht und auf einen entsprechend hergestellten Wafer.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Gemäß der US2012/322227 ist ein Verfahren bekannt, bei welchem eine Zugspannungsschicht auf einem Basissubstrat vorgesehen ist. Die Zugspannungsschicht weist einen Zugspannungsschichtteil, der oberhalb einer oberen Oberfläche des Substrats angeordnet ist, und einen selbsthaftenden Zugspannungsschichtteil auf, der nahe dem Rand jeder Seitenwand des Basissubstrats angeordnet ist. Daraufhin wird oberhalb des Zugspannungsschichtteils des Basissubstrats ein Abspalthemmer aufgebracht und anschließend der selbsthaftende Zugspannungsschichtteil getrennt. Dann wird ein Teil des Basissubstrats durch ein Verschieben des Abspalthemmers abgespalten.

Ferner offenbart die EP1858087 ein Verfahren zur Herstellung dünner Substarte mit einer Dicke von unterhalb 750 Mikrometer. Dabei wird ein Muttersubstrat verwendet, in welches zumindest teilweise eine Spannung eingebracht wird, wobei dieses Verfahren für die Herstellung von Solarzellen verwendet werden kann.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Expansionskoeffizienten auf. Außerdem kann durch Ausnutzen eines Glasübergangs ein relativ hohes Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, wobei außerdem kleine Variationen in den Eigenschaften der Polymerschicht (Geometrie, Elastizitätskonstanten, Temperatur, etc.) oft zu größeren Unregelmäßigkeiten bei dieser Krümmung führen können. Dies erschwert ein kontrolliertes Abspalten, und kann z.B. zu Dickenschwankungen des abgespaltenen Wafers führen. Außerdem erschwert diese Krümmung die weitere Verarbeitung und kann sogar zum Zerbrechen des Wafers führen.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können. Oft verläuft der Bruch beispielsweise in mehreren Bruchfronten entlang verschiedener Richtungen, wobei es bei einem späteren Wiederaufeinandertreffen oder einer ungünstigen Überlagerung dieser Bruchfronten zu großen und oft abrupten Dickenschwankungen beim abgespaltenen Wafer kommen kann.

Außerdem können bei den bisherigen Verfahren im Schichtsystem Polymer-Werkstück unerwünschte lokale Spannungsspitzen entstehen, die zum Zerbrechen des Polymers und/oder des Wafers führen können.

Schließlich besteht auch Bedarf für ein Verfahren, um auf einfache Art externe mechanische Kräfte während des Abkühlvorgangs auf das Schichtsystem ausüben zu können, um den Abspaltprozess und insbesondere die Bruchführung besser beeinflussen zu können.

Bei Verwendung der Verfahren nach dem bisherigen Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Methoden häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Es ist somit Aufgabe der vorliegenden Erfindung ein entsprechendes Verfahren, eine entsprechende Einrichtung und eine entsprechende Vorrichtung zur Herstellung von Festkörperschichten und/oder Festkörperplatten bereitzustellen, welches die Qualität der hergestellten Wafer gegenüber den bekannten Verfahren verbessert, insbesondere indem die Krümmung der abgespaltenen Festkörperschichten bzw. Wafer reduziert wird bzw. eine gleichmäßige Schichtdicke des Wafers erzeugt wird. Weitere Aufgaben der vorliegenden Erfindung sind die bei der Bruchpropagation entstehenden unerwünschten Oszillationen zu vermindern, den Wärmekontakt zum Schichtsystem zu verbessern und zudem die Möglichkeit einer einfacheren und schonenderen Handhabbarkeit der Festkörperschichten und/oder -platten nach dem Abspalten bereitzustellen. Weiterhin soll ein Wafer derart hergestellt werden, dass bei seiner Herstellung die zuvor genannten Nachteile überwunden werden.

Die Lösung der zuvor genannten Aufgabe erfolgt durch den Gegenstand des Anspruchs 1.

Der zu Grunde liegende Wirkungsmechanismus der Erfindung basiert insbesondere auf folgenden Erläuterungen: Durch Videoaufzeichnungen mittels einer Hochgeschwindigkeitskamera wurde von der Anmelderin festgestellt, dass bei dem Verfahren nach dem bisherigem Stand der Technik das Abspalten eines Wafers jeweils an einer bestimmten Stelle am Rand des Wafers (meist an einer Ecke) beginnt. Der Wafer beginnt sich dann zu spalten, indem von dieser Stelle aus üblicherweise zwei Bruchfronten in jeweils entgegengesetzter Umlaufrichtung der Kante des Wafers entlanglaufen und schließlich ungefähr auf der gegenüberliegenden Seite des Wafers wieder aufeinander treffen. Erst danach spaltet sich das Zentrum des Wafers ab. Dieses Verhalten lässt sich dadurch erklären, dass die Kante des Wafers im Vergleich zum Inneren stets signifikant mehr Defekte im Material aufweist, was zu einer lokal verringerten Bruchfestigkeit führt, wodurch schließlich das Abspalten des Wafers entlang der Kante schon bei relativ geringeren Spannungen möglich ist. Das Entstehen von mehreren unterschiedlichen Bruchfronten sowie insbesondere das ungenügend kontrollierte Aufeinandertreffen derselben scheint auf negative Weise zu unerwünschten Dickenschwankungen der abgespalteten Wafer beizutragen.

Der Grundgedanke der vorliegenden Erfindung ist es, definierte (inhomogene) Spannungsverteilungen in das Schichtsystem einzubringen, um den Bruchverlauf gezielt zu beeinflussen, so dass die Dickenschwankungen der abgespalteten Wafer reduziert werden. Dies kann z.B. erreicht werden, wenn weniger unterschiedliche Bruchfronten erzeugt werden und diese an Stellen aufeinandertreffen, wo sie weniger stören (z.B. am Rand des Wafers). Bevorzugt ist z.B. das Erzeugen einer einzigen Bruchfront, die von einer Stelle an einer Kante des Wafers praktisch gradlinig zur gegenüberliegenden Kante des Wafers läuft. Bevorzugte Spannungsverteilungen sind beispielsweise solche, wo die Spannung im Schichtsystem in der Mitte des Wafers größer ist als an den Rändern, oder wo die Spannung entlang einer von einer Waferkante zu einer gegenüberliegenden Waferkante führenden Linie größer ist als in den übrigen Bereichen, oder wo die Spannungsverteilung im Schichtsystem eine im Wesentlichen lineare Symmetrie hat.

Das erfindungsgemäße Verfahren zur Herstellung von Festkörperschichten, insbesondere zur Verwendung als Wafer, umfasst insbesondere die Schritte: Bereitstellen eines Werkstücks zum Ablösen der Festkörperschichten, wobei das Werkstück zumindest eine exponierte Oberfläche aufweist. Erzeugen und/oder Bereitstellen einer Trägereinheit zum Aufnehmen mindestens einer Festkörperschicht, wobei die Trägereinheit eine Aufnahmeschicht zum Halten der Festkörperschicht aufweist. Anbringung der Aufnahmeschicht an der exponierten Oberfläche des Werkstücks unter Bildung einer Kompositstruktur. Erzeugen einer vordefinierten Spannungsverteilung innerhalb des Werkstücks zum Beeinflussen, insbesondere zum definierten Vorgeben, eines Abspaltverlaufs beim Abspalten der Festkörperschicht von dem Werkstück, und Abspalten der Festkörperschicht von dem Werkstück entlang einer sich innerhalb des Werkstücks erstreckenden Ebene gemäß dem durch die vordefinierte Spannungsverteilung beeinflussten Abspaltverlauf.

Mit der vorliegenden Erfindung - der Verwendung von Schichten bzw. Schichtsystemen mit lokal definierbaren Spannungsfeldern - werden auf vorteilhafte Weise alle aus dem Stand der Technik bekannten Probleme und Einschränkungen behoben. Als Werkstück wird in den hier beschriebenen Anwendungsbeispielen vorzugsweise ein dickerer Wafer verwendet, von welchem dann unter Verwendung des beschriebenen Verfahrens ein, zwei, drei oder mehrere, dünnere Wafer, insbesondere zeitgleich oder zeitlich versetzt, abgespaltet werden.

Es wurde mit dem erfindungsgemäßen Verfahren ein Weg gefunden, die Dickenschwankungen massiv zu reduzieren, indem anstatt der nach dem bisherigen Stand der Technik verwendeten homogenen Polymerschichten eine oder mehrere Schicht/en mit lokal vordefinierbaren mechanischen Spannungsfeldern verwendet werden. Mit dem erfindungsgemäßen Verfahren können somit Wafer mit viel geringeren totalen Dickenschwankungen hergestellt werden, wobei bzgl. der räumlichen Dickenverteilung bevorzugt vorteilhaftere lineare Muster erzielt und insbesondere die Bereiche mit den größten Schwankungen in die Nähe des Waferrandes gebracht werden können, wo sie weniger stören.

Die Trägereinheit weist gemäß der vorliegenden Erfindung eine Stabilisierungsschicht auf und die Stabilisierungsschicht wird zumindest abschnittsweise durch die Aufnahmeschicht überlagert.

Diese ist vorteilhaft, da durch das Zusammenwirken unterschiedlicher Schichten die einzelnen Materialeigenschaften und geometrischen Eigenschaften der einzelnen Schichten derart vorsehbar bzw. ausbildbar sind, dass die gewünschten Spannungsverteilungen insbesondere einfach, sicher und reproduzierbar erzeugbar sind.

Gemäß der vorliegenden Erfindung unterscheiden sich die thermischen Ausdehnungskoeffizienten des Materials der Stabilisierungsschicht und des Materials der Aufnahmeschicht zumindest um den Faktor 2, wobei der thermische Expansionskoeffizient der Stabilisierungsschicht bevorzugt kleiner ist als der thermische Expansionskoeffizient der Aufnahmeschicht.

Gemäß er Erfindung werden bevorzugt Schichtbestandteile definierter Geometrie aus verschiedenen Materialien, die sich durch unterschiedliche thermische Expansionskoeffizienten auszeichnen, bevorzugt bei einer höheren Temperatur (z.B. zwischen Raumtemperatur und 150°C) miteinander zu einer Schichtstruktur fest verbunden (z.B. durch Verkleben oder Laminieren). Wird diese Schichtstruktur dann nach der Verfestigung abgekühlt, entstehen durch die unterschiedliche thermische Expansion in der Schichtstruktur auf vorteilhafte Weise lokal definierbare Spannungsfelder. Im Folgenden wird ein Beispiel beschrieben, wie eine solche Schichtstruktur z.B. unter Verwendung von vorgefertigten Polymerfolien und Strukturelementen aus Metall von bestimmter Form hergestellt und zum Abspalten von Wafern verwendet werden kann.

Die Geometrie der Stabilisierungsschicht und/oder der Aufnahmeschicht ist gemäß einer bevorzugten Ausführungsform der vorliegenden Erfindung derart gewählt, dass sie zumindest abschnittsweise die Spannungsverteilung beeinflusst, insbesondere vorgibt.

Gemäß dieser Ausführungsform der Erfindung sind somit auf vorteilhafte Weise lokal kontrollierte Spannungsverteilungen in der Schichtstruktur durch gezielte Wahl der Schichtgeometrie erzeugbar. Beispielsweise führen scharfe Ecken und Kanten in der Polymerschicht zu lokalen mechanischen Spannungsspitzen während abgerundete Ränder diese reduzieren (z.B. beginnt die Bruchpropagation beim Abspalten sehr häufig an einer scharfen Ecke im Schichtsystem). Durch gezieltes Erzeugen von Spannungsspitzen durch Schichtstrukturen mit scharfen Ecken und Kanten kann so der Bruchverlauf präferentiell in diesen Bereichen geführt werden, während die Bruchpropagation durch Bereiche mit abgerundeten Strukturen eher unterdrückt wird.

Gemäß einer weiteren bevorzugten Ausführungsform der vorliegenden Erfindung wird die vorgegebenen Spannungsverteilung durch die Aufbringung mechanischer, elektrischer und/oder magnetischer Kräfte auf die Kompositstruktur beeinflusst, insbesondere vorgegeben.

Externe Kräfte können auch während des Kühlvorgangs vor dem Abspalten des Wafers gezielt auf das Schichtsystem ausgeübt werden. Denkbar ist hierbei, dass die Dicke der abgespalteten Wafer neben den Materialeigenschaften der beteiligten Schichten auch durch solche von außen ausgeübten Kräfte beeinflusst werden kann. Beispielsweise kann das Schichtsystem mit Hilfe von externen Kräften gezogen, gedrückt, verdreht, gekrümmt, eingespannt, etc. werden. In einem Ausführungsbeispiel wurde das Schichtsystem nach der Beschichtung durch externe Kräfte parabolisch in einer Richtung gekrümmt und dann in gekrümmtem Zustand abgekühlt, bis ein Wafer abgespaltet wurde. Dadurch wurde eine bestimmte Richtung in der Spannungsverteilung ausgezeichnet, was gegenüber dem bisherigen Stand der Technik auf vorteilhafte Weise zu deutlich anderen Oberflächenmustern und geringeren Dickenschwankungen führt.

Außerdem können unterschiedliche externe Kräfte separat auf unterschiedliche Teile des Schichtsystems ausgeübt werden. Auch das zeitliche Zusammenspiel der externen Kräfte mit dem Ablauf des Kühlvorgangs ist von Bedeutung: Da wesentliche Materialeigenschaften, wie z.B. Elastizitätsmodule der Polymerschichten, oberhalb der Glasübergangstemperatur wesentlich andere Werte annehmen als unterhalb der Glasübergangstemperatur, ist es für die Spannungsverteilung wichtig, ob externe Kräfte nur oberhalb oder nur unterhalb des Glasübergangs oder bei allen Temperaturen ausgeübt werden. Außerdem können Materialeigenschaften, wie Elastizitätsmodule, insbesondere im Polymer, auch durch das Ausüben von externen Kräften beeinflusst werden (z.B. können sich die Molekülketten des Polymers entlang der externen Kräfte ausrichten, so dass das Polymer anisotrop wird).

Die vorgegebenen Spannungsverteilung wird gemäß einer weiteren bevorzugten Ausführungsform der vorliegenden Erfindung durch eine Temperierung der Stabilisierungsschicht und/oder der Aufnahmeschicht beeinflusst, insbesondere vorgegeben, wobei die Stabilisierungsschicht und/oder die Aufnahmeschicht jeweils lokal unterschiedlich temperiert werden und/oder lokal jeweils unterschiedliche Temperarturverläufe aufweisen.

Die mechanische Spannungsverteilung in der Schichtstruktur ist bevorzugt nicht nur durch den lokalen thermischen Ausdehnungskoeffizienten und das lokale Elastizitätsmodul bestimmt, sondern zusätzlich oder alternativ auch direkt durch die lokale Temperatur bzw. Temperaturverteilung in der Schichtstruktur. Dadurch ist es auch möglich, durch Erzeugen einer gezielten Temperaturverteilung (z.B. unter Verwendung von individuell regelbaren Kühlzonen) in der Schichtstruktur eine gewünschte Spannungsverteilung zu erzeugen. Beispielsweise kann die Schichtstruktur im Bereich der Mitte des Wafers auf tiefere Temperaturen gekühlt werden als die Schichtstruktur im Randbereich des Wafers, was dazu führt, dass die erzeugten mechanischen Spannungen im Randbereich des Wafers kleiner sind als in der Mitte. Selbstverständlich sind auch andere Geometrien für solche Zonen unterschiedlicher Kühlung möglich und im Sinne der Erfindung. Das gezielte lokale Einbringen einer definierten Kühlleistung in das Schichtsystem wird außerdem erleichtert, wenn oberflächliche Strukturelemente aus einem thermisch gut leitenden Material wie z.B. Metall bestehen.

Außerdem hat nicht nur die momentane Temperaturverteilung in der Schichtstruktur einen Einfluss auf die momentane Spannungsverteilung, sondern auch die zeitliche Änderung der Temperatur. Insbesondere hängen viele Materialeigenschaften des Polymers auch von der Kühlrate ab: Beispielsweise kann ein zu schnelles Kühlen (beispielsweise mit Kühlraten über 10K/s) zu Bereichen mit lokalen Spannungsspitzen in der Polymerschicht führen, welche ein Zerbrechen der Polymerschicht bewirken können. Ein kontrolliertes, langsames Kühlen mit Kühlraten kleiner als 10 K/s, insbesondere kleiner als 7 K/s und bevorzugt kleiner als 5K/s erlaubt die Equilibrierung der Spannung im Schichtsystem während des Kühlvorgangs und kann unerwünschte lokale Spannungsspitzen reduzieren, was sich in signifikant geringerer Bruchhäufigkeit der Polymerschicht äußert.

Die Aufnahmeschicht und die Stabilisierungsschicht bestehen gemäß einer weiteren bevorzugten Ausführungsform der vorliegenden Erfindung aus unterschiedlichen Materialien, wobei die Aufnahmeschicht bevorzugt ein Polymer, insbesondere Polydimethylsiloxane (PDMS), aufweist und die Stabilisierungsschicht bevorzugt ein Metall, insbesondere Aluminium, aufweist.
Die Aufnahmeschicht wird bevorzugt durch mindestens ein Polymer gebildet, wobei das mindestens eine Polymer bzw. das sich aus mehreren Werkstoffen ergebende Polymer bevorzugt aus einem oder mehreren Duroplasten und/oder aus einem oder mehreren Elastomeren und/oder aus einem oder mehreren Thermoplasten und/oder aus einem oder mehreren thermoplastischen Elastomeren bestehen oder zumindest teilweise gebildet wird. Das Polymer weist somit bevorzugt mindestens einen Kunststoff, insbesondere mindestens ein Elastomer, insbesondere mindestens ein Silicon, insbesondere mindestens ein RTV-Silicon und/oder mindestens ein HTV-Silicon, insbesondere mindestens ein Polydimethylsiloxan (PDMS) auf oder besteht bevorzugt aus mindestens einem Kunststoff, insbesondere mindestens einem Elastomer, insbesondere mindestens einem Silicon, insbesondere mindestens einem RTV-Silicon und/oder mindestens einem HTV-Silicon, insbesondere mindestens ein Polydimethylsiloxan (PDMS).Als Polymer kann somit besonders bevorzugt z.B. ein Polydiorganolsiloxan verwendet werden, z.B. Polydimethylsiloxane (PDMS). Im Folgenden wird als Polymerschicht bzw. Aufnahmeschicht bevorzugt eine Folie aus PDMS verwendet.

Die Erfindung beschreibt somit in anderen Worten ein Verfahren zur Herstellung von dünnen Platten bzw. Festkörperschichten aus Werkstoffen geringer Duktilität, insbesondere unter Verwendung von einer oder mehreren Aufnahmeschicht/en, insbesondere Polymerschichten, mit lokal definierbaren mechanischen Spannungsfeldern und/oder mit einer oder mehreren Stabilisierungsschicht/en, insbesondere Metallschichten bzw. Metallplatten.

Durch die beschriebenen Ausführungsformen wurde dargestellt, wie Schichtstrukturen bestehend aus mindestens einer Aufnahmeschicht, insbesondere einer Polymerschicht, und mindestens einer Stabilisierungsschicht, insbesondere Strukturelementen aus anderen Materialien (insbesondere Materialien mit wesentlich kleineren thermischen Expansionskoeffizienten als die verwendeten Polymere, also insbesondere Metalle), zur Lösung der eingangs erwähnten Probleme bei der Herstellung von Festkörperschichten bzw. Wafern verwendet werden können. Um entsprechende Schichtstrukturen, die aus Komponenten mit jeweils unterschiedlichen thermischen Expansionskoeffizienten bestehen, zu erzeugen, müssen aber nicht unbedingt unterschiedliche Materialien kombiniert werden: Es ist z.B. auch möglich, durch unterschiedliche Bearbeitung des verwendeten Polymers (insbesondere unterschiedliche Härtung) Polymerschichten mit unterschiedlichen thermischen Expansionskoeffizienten herzustellen. Außerdem hängt der thermische Expansionskoeffizient sowie das Elastizitätsmodul des verwendeten Polymers stark von der Temperatur ab (mit einem ausgeprägten Glasübergang bei ca. -125°C, wo z.B. das Elastizitätsmodul um mehrere Größenordnungen ansteigt). Es ist deshalb auch möglich, durch gezieltes Erzeugen von Bereichen / Schichten unterschiedlicher Temperatur im Polymer entsprechende Bereiche / Schichten mit unterschiedlichem thermischen Expansionskoeffizienten und Elastizitätsmodul zu erzeugen. Auch andere physikalische Größen als die Temperatur können unter Umständen lokal den thermischen Expansionskoeffizienten einer entsprechenden Polymerschicht beeinflussen (z.B. Schwellen durch Lösungsmittel) und können dann zur gezielten Erzeugung von Bereichen / Schichten mit unterschiedlichem thermischen Expansionskoeffizienten verwendet werden.

Die Aufnahmeschicht wird gemäß einer weiteren bevorzugten Ausführungsform der vorliegenden Erfindung als Folie erzeugt und die Aufnahmeschicht wird zur Ausbildung der Trägereinheit mit der Stabilisierungsschicht stoffschlüssig verbunden, wobei die Aufnahmeschicht, insbesondere mittels einer Klebeschicht, plasmaaktiviertem Kleben oder Auflaminieren mit der Stabilisierungsschicht verbunden wird.

Als Polymer kann z.B. ein Polydiorganolsiloxan verwendet werden, z.B. Polydimethylsiloxane (PDMS). Im Folgenden wird als Polymerschicht eine Folie aus PDMS, als Strukturelemente Aluminiumplatten und als Werkstück ein dicker Wafer aus Silizium beschrieben; es können aber auch andere geeignete Polymere, Strukturelementmaterialien und Werkstücke (z.B. aus anderen Materialien wie Galliumarsenid, Germanium, Galliumnitrid, Siliziumcarbid, Saphir, etc.) verwendet werden.

Zur Herstellung der Polymerfolien ist bevorzugt PDMS verwendbar. Dies ist ein zweikomponentiges Gemisch, das thermisch ausgehärtet wird (z.B. Mischverhältnisse zwischen Härter: Basismaterial von bevorzugt 1:100 bis 1:1 und besonders bevorzugt von 1:30 bis 1:3). Zum Härten sind -je nach Härtezeit - Härtetemperaturen von Raumtemperatur bis ca. 300°C und bevorzugt bis 200°C, vorzugsweise von Raumtemperatur bis ca. 120°C, vorsehbar. Bevorzugt sind Härtezeiten zwischen ca. 1-120 Minuten (bei hohen Temperaturen) und 1-6 Tagen (bei Raumtemperatur) vorsehbar. Bei PDMS handelt es sich vor dem Härten um eine viskose Flüssigkeit, die z.B. mittels Gießverfahren auf eine bevorzugt glatte Oberfläche (z.B. einen Spiegel) aufgebracht wird und dort zu einer Folie aushärtet. Die Folie wird von dieser Oberfläche dann abgezogen (z.B. mechanisch), gegebenenfalls weiterverarbeitet, und danach auf die zu beschichtende Oberfläche aufgebracht. Außerdem kann die fertige Folie bereits vordem Aufbringen untersucht und ihre Qualität überprüft werden (z.B. mit üblichen mechanischen, optischen oder elektrischen Messverfahren, etc.). Neben dem hier beschriebenen Verfahren zur Folienherstellung sind viele andere Verfahren in der Industrie üblich (z.B. Herstellung durch Extrusion), welche ebenfalls für die vorliegende Erfindung anwendbar sind.

Auf eine so hergestellte erste Folie werden danach Strukturelemente aus einem anderen Material aufgeklebt. Im Folgenden wird als Strukturelement eine Platte aus Aluminium beschrieben; es können aber auch Strukturelemente aus anderen geeigneten Materialien (z.B. Messing, Stahl, Silizium, Glas etc.) verwendet werden. Wichtig ist, dass sich die thermischen Expansionskoeffizienten von Folie und Strukturelementen genügend stark unterscheiden (bevorzugt zumindest um einen Faktor 2 bis 5). Aluminium beispielsweise besitzt einen um ungefähr zwei Größenordnungen kleineren thermischen Expansionskoeffizienten als PDMS. Die Strukturelemente sind dabei in einer vordefinierten Form gefertigt, um die gewünschten Spannungsfelder zu erzeugen. Im vorliegenden Beispiel wird z.B. eine Metallplatte verwendet, deren Fläche die Form des Wafers hat, die aber etwas (2 bis 10 mm) kleiner ist, so dass die Ränder des Wafers durch die Metallplatte nicht abgedeckt werden.

Wichtig ist auch eine gute Haftung zwischen Folie und Strukturelementen: die Verbindung zwischen Strukturelementen und Folie muss genügend große Scherkräfte für das Abspalten sowie genügend große Temperaturschwankungen für das thermische Induzieren der nötigen Spannungen aushalten können. Die Haftung kann z.B. durch mechanisches Aufrauen der Metalloberfläche, Eloxieren des Aluminiums, Ätzprozesse, etc. verbessert werden.

Für das Aufkleben der Folie bietet sich ein dünner PDMS-Film als Kleber an. Das PDMS wird in diesem Beispiel im flüssigen Zustand auf beide zu verklebenden Oberflächen dünn aufgetragen (einige Milliliter für einen 6-inch Wafer). Danach wird die Folie auf die Metallplatte aufgelegt und mit einer Rolle oder Walze unter leichtem Druck angepresst. Durch Hin- und Herbewegen der Rolle verteilt sich der Kleberfilm unter der Folie, Luftblasen werden entfernt. Die Aushärtung des Klebers kann bei Temperaturen zwischen Raumtemperatur und ca. 200°C erfolgen. Die Härtezeiten variieren, wie bei der Folienherstellung, abhängig von der Härtetemperatur (siehe oben). Alternativ zur beschriebenen Methode kann die Folie auch mit anderen üblichen Verfahren auf die Metallplatte aufgeklebt werden, z.B. unter Verwendung eines Vakuum-Laminators. Schließlich kann die Folie auch direkt (ohne Kleber) mit der Oberfläche der Metallplatte verbunden werden, z.B. mittels "Plasma activated bonding" (z.B. Aktivierung der PDMS-Folie in Stickstoffplasma, Aufpressen der Folie auf die Metallplatte, ggf. "Annealing") oder z.B. durch Auflaminieren (Aufschmelzen) einer thermoplastischen Folie (z.B. Geniomer von Wacker Silicones).

Nach dem Aufkleben der ersten Polymerfolie auf die Metallplatte und Aushärten des Klebers wird mit einem analogen Verfahren das Werkstück (im vorliegenden Beispiel ein dicker Siliziumwafer) auf die erste Polymerfolie geklebt.

Gemäß einer weiteren bevorzugten Ausführungsform der vorliegenden Erfindung ist die Aufnahmeschicht strukturiert und die Aufnahmeschicht wird durch die Aufbringung eines zumindest zeitweise fließfähigen Materials auf die Stabilisierungsschicht und eine Verfestigung des Materials ausgebildet.

Diese Ausführungsform ist vorteilhaft, da es dadurch auch möglich ist eine oder beide der verwendeten Polymerschichten, insbesondere die Aufnahmeschicht und/oder eine Verbindungsschicht, nicht als vorgefertigte Folie aufzukleben, sondern direkt in situ herzustellen. Beispielsweise können sowohl Strukturelemente wie auch Wafer mit Hilfe einer Schalungsvorrichtung direkt mit flüssigem PDMS zu einer Kompositstruktur vergossen werden.

Das Werkstück wird gemäß einer weiteren bevorzugten Ausführungsform der vorliegenden Erfindung vor der Verfestigung des Materials mit dem Material in Kontakt gebracht, wobei das Werkstück zumindest abschnittsweise in das Material eintaucht, wobei die Eintauchtiefe einstellbar ist, insbesondere mittels einer Erhöhung der vom Werkstück auf die Trägereinheit ausgeübten Normalkraft oder durch die Einbringung von Abstandshaltern.

Gemäß diesem Ausführungsbeispiel kann somit auf vorteilhafte Weise vollständig auf das Kleben von vorgefertigten Polymerfolien verzichtet werden. Dabei wird, wie oben beschrieben, ein flüssiges Material, insbesondere ein flüssiges Polymer, wie vorzugsweise PDMS, direkt auf die Metallplatte aufgebracht, wobei diese bevorzugt horizontal ausgerichtet und an den Rändern bevorzugt mit einem geeigneten Abschluss (Schalung) versehen ist, welche besonders bevorzugt das Überfließen des PDMS verhindert. Dadurch entsteht eine Art Becken gefüllt mit flüssigem PDMS. Das Werkstück (der Wafer) wird bevorzugt allseitig mit einer dünnen Schicht flüssigem PDMS benetzt und dann in das Becken mit flüssigem Material, insbesondere ein PDMS-Becken, getaucht (die vorherige Benetzung mit PDMS reduziert die Bildung von Luftblasen an der Waferoberfläche). Durch die Schwerkraft sinkt das Werkstück bzw. der Wafer an den Boden des Beckens, wo er in geringem Abstand zur Oberfläche der Stabilisierungsschicht bzw. der Metallplatte zur Ruhe kommt.

Diese Ausführungsform ist vorteilhaft, da die Distanz derart einstellbar ist, dass das Werkstück in geeigneter Weise über die Aufnahmeschicht mit der Stabilisierungsschicht koppelbar bzw. wirkverbindbar ist.

Die Distanz zwischen dem Werkstück bzw. Waferoberfläche und der Stabilisierungsschicht bzw. der Metallplatte ist bevorzugt durch das Gleichgewicht zwischen Schwerkraft / Auftrieb des Wafers und Oberflächenspannung des PDMS an der Wafer- und Metalloberfläche bestimmt. Diese Distanz kann durch künstliches Erhöhen der Schwerkraft (z.B. mittels einer Zentrifuge) verringert werden, oder kann durch Einpassen von vorzugsweise dünnen mechanischen Abstandshaltern die vorzugsweise selbst aus PDMS bestehen können, zwischen Werkstück bzw. dem Wafer und der Stabilisierungsschicht bzw. der Metallplatte vergrößert werden. Diese Distanz bestimmt bevorzugt die Dicke der ersten Polymerschicht (zwischen Metallplatte und Wafer), die Dicke der zweiten Polymerschicht (auf der gegenüberliegenden Seite des Wafers) wird bevorzugt durch die Menge an PDMS im Becken bestimmt. Das PDMS wird anschließend ausgehärtet, und danach werden, wie bezüglich einer vorher beschriebenen Ausführungsform bereits beschrieben, bevorzugt die seitlichen Ränder der Polymerschichten in einem definierten Abstand zum Werkstückrand bzw. Waferrand getrimmt, beispielsweise bündig zum Werkstückrand bzw. Waferrand.

Gemäß einer weiteren bevorzugten Ausführungsform der vorliegenden Erfindung wird eine Verbindungsschicht, insbesondere ein Polymer und bevorzugt Polydimethylsiloxane (PDMS) aufweisend, auf das Werkstück aufgebracht, wobei die Verbindungsschicht im Wesentlichen parallel zur Aufnahmeschicht angeordnet ist und die im Wesentlichen zueinander parallelen Anteile der Verbindungsschicht und der Aufnahmeschicht durch das sich dazwischen erstreckende Werkstück voneinander beabstandet sind.

Diese Ausführungsform ist vorteilhaft, da beispielsweise nach dem Aufkleben der Aufnahmeschicht bzw. der ersten Polymerfolie auf die Stabilisierungsschicht bzw. die Metallplatte und dem Aushärten des Klebers, insbesondere PDMS, mit einem analogen Verfahren das Werkstück (im vorliegenden Beispiel ein dicker Siliziumwafer) auf die Aufnahmeschicht bzw. die erste Polymerfolie geklebt wird, und danach - wieder mit einem analogen Verfahren - eine zweite, im Allgemeinen bzw. im Wesentlichen dickere Polymerfolie, insbesondere die Verbindungsschicht, auf die noch freie Seite des Werkstücks bzw. Wafers geklebt wird. Zum Schluss werden im vorliegenden Beispiel die seitlichen Ränder aller Polymerfolien (insbesondere der Aufnahmeschicht und der Verbindungsschicht) getrimmt, so dass sie mit dem Werkstückrand bzw. mit dem Waferrand bündig abschließen.

Die zuvor beschriebenen Ausführungsformen verwenden bevorzugt ein asymmetrisches Schichtsystem bestehend aus Metall-Polymer-Wafer-Polymer, wobei die Polymerschicht (d.h. die Aufnahmeschicht) zwischen Metall und Wafer wesentlich dünner als diejenige Polymerschicht (d.h. die Verbindungsschicht) auf der gegenüberliegenden Seite des Wafers ist. Selbstverständlich kann das vorliegende Verfahren aber auch mit anderen Schichtsystemen angewandt werden, insbesondere symmetrische Schichtsysteme bestehend aus Metall-Polymer-Wafer-Polymer-Metall sowie Metall-Polymer-Wafer-Polymer-Wafer-Polymer-Metall sind bereits erfolgreich getestet worden.

Nachdem das Laminat Metallplatte-Polymerschicht-Werkstück-Polymerschicht z.B. unter Verwendung eines der vorher beschriebenen Ausführungsbeispiele hergestellt und das Polymer ausgehärtet ist, wird wie in den im Stand der Technik beschriebenen Referenzen üblich, z.B. durch thermisch induzierte Spannungen, ein dünner Wafer vom Werkstück abgelöst, wobei ein Teil des Laminats (in den beschriebenen Beispielen die zweite Polymerschicht bzw. die Verbindungsschicht) noch auf einer Seite des Werkstücks bzw. des Wafers anhaftet. Dieser Laminatteil kann dann vom hergestellten Wafer z.B. mit mechanischen oder chemischen Methoden abgelöst werden, wie in den erwähnten Referenzen dargestellt. Am verbleibenden Rest des Werkstücks haftet entsprechend auf einer Seite noch der andere Teil des Laminats (in den beschriebenen Beispielen die erste Polymerschicht bzw. die Aufnahmeschicht und daran die Metallplatte bzw. die Stabilisierungsschicht). Auch dieser Rest kann z.B. mit mechanischen oder chemischen Methoden abgelöst werden, wie in den erwähnten Referenzen dargestellt. Um das Ablösen der Laminate nach dem Abspalten des Wafers zu erleichtern, kann es zudem hilfreich sein, das Laminat leicht zu krümmen, was insbesondere dank der verbundenen Metallplatte einfach und kontrolliert möglich ist.

Unabhängig von der Ausführungsform gilt bevorzugt: Die benötigten Dicken und Materialeigenschaften (insbesondere thermische Expansionskoeffizienten und Elastizitätsmodule) der verwendeten Polymerschichten sowie der Metallplatte hängen von den Dicken und Materialeigenschaften des Werkstücks sowie der gewünschten Zieldicke des abzuspaltenden Wafers ab. Bei den hier beschriebenen Anwendungsbeispielen wird ein 400 Mikrometer dicker, monokristalliner, pseudoquadratischer 6-inch Siliziumwafer mit <100> Orientierung hälftig in zwei 200 Mikrometer dicke Wafer gespalten. Dazu werden die folgenden Dicken verwendet: Die Stabilisierungsschicht bzw. Metallplatte Aluminium aufweisend oder aus Aluminium bestehend ist zwischen 0.1mm und 10mm bevorzugt zwischen 0.25mm und 7.5mm und besonders bevorzugt zwischen 0.5mm und 5mm Millimeter dick, die Aufnahmeschicht bzw. eine erste Polymerschicht (zwischen Metallplatte und Werkstück) ist bevorzugt zwischen 0.1mm und 10mm, insbesondere zwischen 0.2mm und 5mm dick, eine Verbindungsschicht bzw. eine zweite Polymerschicht ist bevorzugt zwischen 0.1mm und 20mm, insbesondere zwischen 0.2mm und 10mm dick. Die seitlichen Abmessungen der Polymerschichten entsprechen jeweils denen des Wafers, wobei die Ränder bündig mit dem Waferrand übereinander liegen. Die seitlichen Abmessungen der Metallplatte sind, wie erwähnt, etwas kleiner, so dass der Waferrand relativ zur Metallplatte gesehen jeweils ca. 2mm bis 10mm vorsteht.

Die Stabilisierungsschicht und die Aufnahmeschicht werden gemäß einer weiteren bevorzugten Ausführungsform der vorliegenden Erfindung derart miteinander verbunden, dass definierte Spannungen zwischen diesen Schichten übertragen werden.

Diese Ausführungsform ist vorteilhaft, da die aufgebrachten bzw. aufzubringenden Spannungen bzw. Spannungsfelder wiederholbar bei verschiedenen Werkstücken oder verschiedenen Werkstückanteilen einleitbar sind.

In weiteren Ausführungsbeispielen werden direkt bei der Herstellung lokal definierte Spannungsverteilungen in die Schichtstruktur mit eingebaut. Dies kann beispielsweise wie folgt erreicht werden: Bevor z.B. eine Polymerschicht (z.B. eine vorgefertigte Polymerfolie) mit einer anderen Schicht verbunden (z.B. aufgeklebt) wird, wird diese Polymerschicht mit einer definierten mechanischen Vorspannung beaufschlagt. Dies kann z.B. geschehen, indem die Polymerfolie vor dem Aufkleben durch definierte äußere Kräfte in einer oder mehreren Richtungen unter Zugspannung gesetzt wird, beispielsweise durch externes mechanisches Ziehen an den Folienrändern oder durch externes mechanisches Krümmen der Folie. Nach dem Aushärten des Klebers werden die äußeren Kräfte ausgeschaltet, aber die Polymerfolie verbleibt unter Zugspannung, während die damit verbundene Schicht nun unter Kompressionsspannung ist. Analog kann die Polymerfolie natürlich auch unter Kompression- und die andere Schicht unter Zugspannung gesetzt werden. Außerdem können äußere Kräfte auch zum Vorspannen von beliebigen anderen Komponenten des Schichtsystems verwendet werden: so kann z.B. anstelle oder zusätzlich zur Polymerschicht auch der Wafer durch externe Kräfte vor dem Verkleben unter Zugspannung gesetzt oder gekrümmt werden. Außerdem können auch nur Teilbereiche der einzelnen Schichten oder Strukturen im Schichtsystem entsprechend vorgespannt sein und diese können auch untereinander unterschiedliche Vorspannungen aufweisen, welche sich sowohl in der Richtung als auch im Betrag unterscheiden. Schließlich können solche in der Schichtstruktur eingebaute Spannungsverteilungen auch z.B. chemisch (beispielsweise durch unterschiedliches Quellen) oder z.B. durch Einwirkung von äußeren elektromagnetischen Feldern erzeugt werden.

Eine weitere präferierte Realisierung der vorliegenden Erfindung besteht darin, Schichtstrukturen nach einem der hier beschriebenen Verfahren auf beiden gegenüberliegenden Seiten eines dicken Wafers aufzukleben. Dadurch kann der dicke Wafer in zwei dünne Wafer aufgespalten werden.

Gemäß einer weiteren bevorzugten Ausführungsform der vorliegenden Erfindung weist die Aufnahmeschicht bevorzugt ein Polymer auf bzw. besteht zumindest teilweise und besonders bevorzugt vollständig aus einem Polymer, wobei beim Beaufschlagen der Kompositstruktur, die bevorzugt zumindest aus der Aufnahmeschicht und dem Werkstück besteht, mit einem inneren und/oder äußeren Spannungsfeld mindestens ein Teil und bevorzugt mehrere Teile des Polymers, insbesondere PDMS, durch genau einen Glasübergang, mindestens einen Glasübergang oder mehrere, insbesondere zeitliche versetzte, Glasübergänge gehen. Es ist hierbei denkbar, dass das Initiieren des Glasübergangs infolge z.B. mechanischer und/oder chemischer und/oder thermischer und/oder akustischer Effekte bzw. Beaufschlagungen bewirkt wird.

Die Erfindung bezieht sich ebenfalls auf eine Vorrichtung zum Herstellen von Festkörperschichten, insbesondere von Wafern. Die Vorrichtung umfasst mindestens eine Beaufschlagungseinrichtung zum Beaufschlagen des Werkstücks mit Spannungen zum Abspalten einer Festkörperschicht und eine Trägereinheit, wobei die Trägereinheit eine Stabilisierungsschicht aufweist und die Stabilisierungsschicht zumindest abschnittsweise durch eine Aufnahmeschicht überlagert ist, wobei die Aufnahmeschicht zum Halten der Festkörperschicht ausgebildet ist, und wobei die Stabilisierungsschicht zumindest abschnittsweise derart ausgebildet wird, dass sie einen thermischen Ausdehnungskoeffizienten aufweist, der kleiner ist als der thermische Ausdehnungskoeffizient der Aufnahmeschicht.

Ferner bezieht sich die vorliegende Erfindung ebenfalls auf eine Trägereinheit zum Aufnehmen mindestens einer Festkörperschicht, insbesondere zur Verwendung in einer Vorrichtung gemäß Anspruch 14, wobei die Trägereinheit eine Stabilisierungsschicht aufweist und die Stabilisierungsschicht zumindest abschnittsweise durch eine Aufnahmeschicht überlagert wird, wobei die Aufnahmeschicht zum Halten der Festkörperschicht ausgebildet ist, und wobei die Stabilisierungsschicht zumindest abschnittsweise derart ausgebildet wird, dass sie einen thermischen Ausdehnungskoeffizienten aufweist, der kleiner ist als der thermische Ausdehnungskoeffizient der Aufnahmeschicht.

Weiterhin bezieht sich die vorliegende Erfindung ebenfalls auf einen Wafer, der nach einem der beschriebenen Herstellungsverfahren, insbesondere gemäß einem oder mehreren der Ansprüche 1 bis 13, hergestellt wird.

Weiterhin werden die Gegenstände der Druckschriften PCT/US2008/012140 und PCT/EP2009/067539 vollumfänglich durch Bezugnahme zum Gegenstand der vorliegenden Patentanmeldung gemacht. Ebenso werden die Gegenstände zweier am Anmeldetag der vorliegenden Patentanmeldung von der Anmelderin ebenfalls eingereichten und das Gebiet der Herstellung von Festkörperschichten betreffenden weiteren Patentanmeldungen vollumfänglich zum Gegenstand der vorliegenden Patentanmeldung gemacht.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1 %-5%, insbesondere von 1 %-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft erfindungsgemäße Wafer, Trägereinheiten und Vorrichtungen dargestellt sind. Bauteile oder Elemente der erfindungsgemäßen Wafer, Trägereinheiten und Vorrichtungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Darin zeigt:
- Fig. 1a: eine erste schematische Darstellung einer Schichtanordnung gemäß dem Gegenstand der vorliegenden Erfindung;
- Fig. 1b: eine zweite schematische Darstellung einer Schichtanordnung gemäß dem Gegenstand der vorliegenden Erfindung;
- Fig. 1c: eine dritte schematische Darstellung einer Schichtanordnung gemäß dem Gegenstand der vorliegenden Erfindung;
- Fig. 1d: eine erste schematische Darstellung der Erzeugung einer Aufnahmeschicht auf einer Stabilisierungsschicht;
- Fig. 1e: eine zweite schematische Darstellung der Erzeugung einer Aufnahmeschicht auf einer Stabilisierungsschicht;
- Fig. 2a: ein erster definierter Spannungsverlauf innerhalb einer ersten bevorzugten Grundform eines Werkstücks;
- Fig. 2b: ein zweiter definierter Spannungsverlauf innerhalb der ersten bevorzugten Grundform eines Werkstücks;
- Fig. 2c: ein dritter definierter Spannungsverlauf innerhalb der ersten bevorzugten Grundform eines Werkstücks;
- Fig. 2d: ein vierter definierter Spannungsverlauf innerhalb der ersten bevorzugten Grundform eines Werkstücks;
- Fig. 2e: ein fünfter definierter Spannungsverlauf innerhalb der ersten bevorzugten Grundform eines Werkstücks;
- Fig. 2f: ein sechster definierter Spannungsverlauf innerhalb der ersten bevorzugten Grundform eines Werkstücks;
- Fig. 3a: ein weiterer definierter Spannungsverlauf in einer zweiten bevorzugten Grundform des Werkstücks;
- Fig. 3b: noch einen weiteren definierten Spannungsverlauf in der zweiten bevorzugten Grundform des Werkstücks;

- Fig. 3c: noch einen weiteren definierten Spannungsverlauf in der zweiten bevorzugten Grundform des Werkstücks;
- Fig. 3d: noch einen weiteren definierten Spannungsverlauf in der zweiten bevorzugten Grundform des Werkstücks;
- Fig. 3e: noch einen weiteren definierten Spannungsverlauf in der zweiten bevorzugten Grundform des Werkstücks; und
- Fig. 4: eine schematische Darstellung eines bevorzugten Ablaufs des erfindungsgemäßen Herstellungsverfahrens.

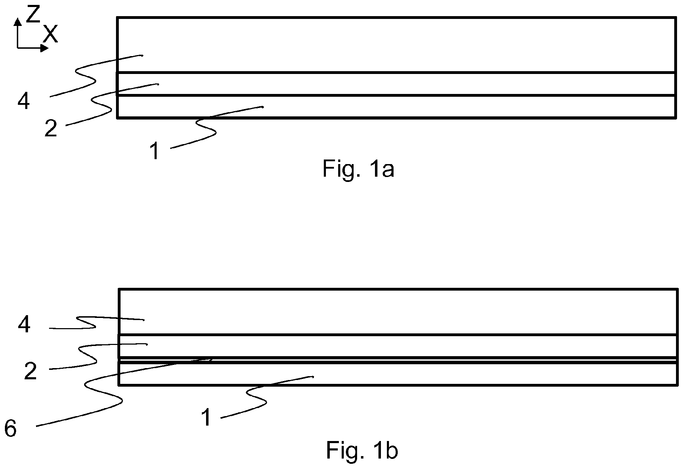

In Fig. 1a ist eine erste schematische Querschnittsdarstellung des erfindungsgemäßen Schichtaufbaus dargestellt. Der Schichtaufbau weist gemäß dieser Darstellung zumindest eine Stabilisierungsschicht 1, eine darüber bzw. daran bzw. darauf angeordnete Aufnahmeschicht 2 und ein darüber bzw. daran bzw. darauf angeordnetes Werkstück 4 auf.

Die einzelnen Schichten 1, 2, 4 können sich dabei in X, Y und Z Richtung gleich weit erstrecken, wobei auch denkbar ist, dass sich nur einzelne dieser Schichten in eine oder mehrere Richtungen gleich weit erstrecken. Bevorzugt erstrecken sich die einzelnen Schichten 1, 2, 4 zumindest in Z-Richtung jeweils unterschiedlich weit.

In Fig. 1b ist der in Fig. 1a gezeigte Schichtaufbau durch eine Klebeschicht 6, die zwischen der Stabilisierungsschicht 1 und der Aufnahmeschicht 2 ausgebildet ist, ergänzt. Die Klebeschicht 6 kann dazu verwendet werden die Stabilisierungsschicht 1 mit der Aufnahmeschicht 2 zu verbinden. Es sind jedoch Ausführungsformen denkbar, in denen auf eine Klebeschicht 6 verzichtet werden kann.

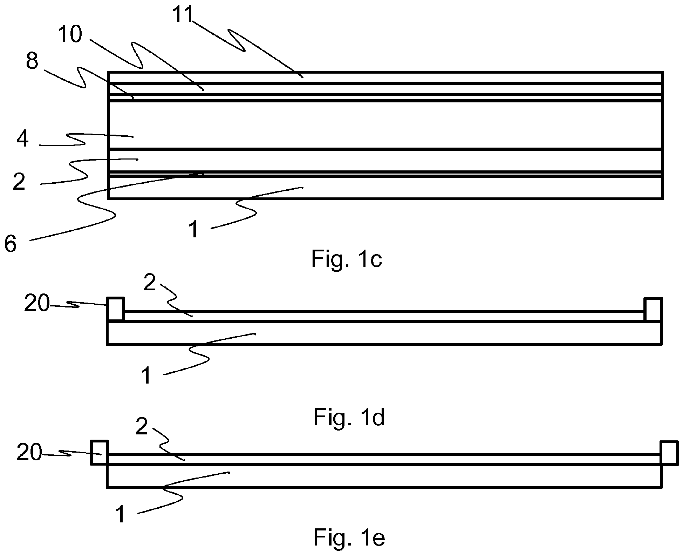

In Fig. 1c ist der in Fig. 1b gezeigte Schichtaufbau durch eine Verbindungsschicht 8, eine weitere Aufnahmeschicht 10 und eine weitere Schicht 11 ergänzt. Die Verbindungsschicht 8 wirkt dabei bevorzugt wie die Klebeschicht 6 und verbindet die weitere Aufnahmeschicht 10 mit dem Werkstück 4. Mit der weiteren Aufnahmeschicht 10 ist weiterhin bevorzugt eine weitere Schicht 11 verbunden, die besonders bevorzugt als weiteres Werkstück 4 oder als weitere Stabilisierungsschicht ausgebildet sein kann.

Ferner ist denkbar, dass zwischen der weiteren Aufnahmeschicht 10 und der weiteren Schicht 11 eine weitere Klebeschicht vorgesehen ist. Ebenso ist vorstellbar, dass die Verbindungsschicht 8 nur optional vorhanden ist.

In Fig. 1d ist eine Stabilisierungsschicht 1 gezeigt, auf der eine Fassung 20 angeordnet ist. Die Fassung 20 erstreckt sich bevorzugt vollständig in Umfangsrichtung der Stabilisierungsschicht 1 und ist besonders bevorzugt mit der Stabilisierungsschicht 1 in Kontakt bringbar. Gemäß der Darstellung Fig. 1d ist der Innendurchmesser der Fassung 20 kleiner als der Außendurchmesser der Stabilisierungsschicht 1. Der durch die Fassung 20 und die Stabilisierungsschicht 1 begrenzte Innenraum dient zur Aufnahme von fließfähigem, insbesondere flüssigem, Material. Das Material erstarrt nach dem zuführen in den Innenraum unter Ausbildung einer im Wesentlichen oder genau ebenen Schicht, insbesondere der Aufnahmeschicht 2.

Gemäß der Fig. 1e ist Fassung 20 größer als in der in Fig. 1d gezeigten Ausführungsform, wodurch die auf der Stabilisierungsschicht 1 erzeugte Aufnahmeschicht 2 bevorzugt im Wesentlichen und besonders bevorzugt vollständig die sich in der X-/Y-Ebene erstreckende Oberfläche der Stabilisierungsschicht 1 überlagert.

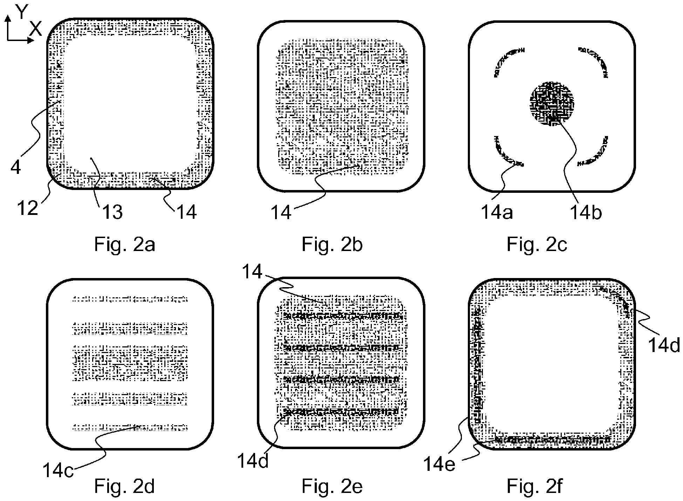

In den Figuren 2a-2f sind diverse definierte Spannungsfelder 14 dargestellt, wobei die gezeigten Spannungsfelder lediglich als Beispiele anzusehen sind, da beliebige weitere Kombinationen der gezeigten Spannungsfelder und/oder anders geformte Spannungsfelder vorgesehen werden können. Die dargestellt Werkstückgrundform kann zudem ebenfalls variieren, wobei die Werkstückgrundform (insbesondere in der X-/Y-Ebene) bevorzugt symmetrisch ist. Rein exemplarisch ist die Werkstückgrundform pseudoquadratisch dargestellt.

In Fig. 2a ist in einem Randbereich 12 des Werkstücks 4 eine durch die Schraffierung gekennzeichnete Spannungsverteilung 14 eingeleitet, die sich von der Spannungsverteilung 13 im Rest des Werkstücks unterscheidet. Gemäß dem Gegenstand der vorliegenden Erfindung lässt sich aufgrund der lokal vorsehbaren definierten Spannungsverteilung/en 14 eine Rissausbreitung beim Abspalten einer Werkstoffschicht vom Werkstück 4 auf besonders vorteilhafte Weise beeinflussen bzw. kontrollieren.

Gemäß der Darstellung 2b ist die Spannungsverteilung invers zu der in Fig. 2a gezeigten Spannungsverteilung in das Werkstück 4 induziert. Es ist hierbei denkbar, dass die Spannung innerhalb eines definierten Spannungsbereichs 14 im Wesentlichen homogen ist. Es ist jedoch ebenfalls denkbar, dass die Spannung innerhalb eines definierten Spannungsbereichs 14 stark variiert, insbesondere abschnittsweise ein Vielfaches der Spannung eines weiteren mit Spannungen beaufschlagten Bereichs aufweist.

In Fig. 2c ist eine Spannungsverteilung gezeigt, die mehrere ringförmige oder teilringförmige Anteile 14a und einen scheibenförmigen Anteil 14b aufweist. Es ist hierbei vorstellbar, dass zusätzlich oder alternativ zu einzelnen oder allen der gezeigten Anteile 14a, 14b sich flächig und/oder linienförmig, insbesondere geradlinig, erstreckende Anteile induzierbar sind.

In Fig. 2d sind sich zumindest abschnittsweise und bevorzugt vollständig geradlinig erstreckende Spannungsverteilungen 14c dargestellt. Die Anzahl der sich geradlinig erstreckenden Spannungsverteilungen 14c kann, wie dargestellt, genau 5 sein, wobei bevorzugt beliebig viele - auch unterschiedlich geformter Spannungsverteilungen -, insbesondere 1, 2, 3, 4, 5, 6, 7, 8, 9, 10 oder mehr, induziert werden können. Die einzelnen Spannungsverteilungen 14 können dabei in konstanten Abständen zueinander induzierbar sein, wobei sie besonders bevorzugt in beliebigen Abständen zueinander induzierbar sind. Bevorzugt nehmen die induzierten Spannungen 14c ausgehend vom Rand des Werkstücks 4 in Richtung Zentrum des Werkstücks 4 zu. Dies ist insbesondere dadurch dargestellt, dass die Flächen der einzelnen Spannungsfelder 14c ansteigen je näher sie zu dem Zentrum des Werkstücks 4 sind. Zusätzlich oder alternativ ist denkbar, dass die Spannungsfelder ähnliche oder gleiche Flächengrößen aufweisen jedoch in der induzierten Spannungsintensität voneinander abweisen. Es ist ebenso vorstellbar, dass die Spannungen zum Zentrum hin abnehmen.

In Fig. 2e ist eine Spannungsverteilung dargestellt, deren Intensität von Werkstückrand in Richtung Werkstückzentrum in Stufen zunimmt. Es ist jedoch ebenfalls denkbar, dass die Spannungsintensität kontinuierlich zunimmt.

In Fig. 2f ist in den Randbereich 12 des Werkstücks 4 eine Grundspannung induziert, Weiterhin sind lokal definierte weitere Spannungsverteilungen 14d, 14e induziert. Analog zu den Figuren 2a und 2b kann die in Fig. 2f gezeigte Spannungsverteilung auch invers induziert werden.

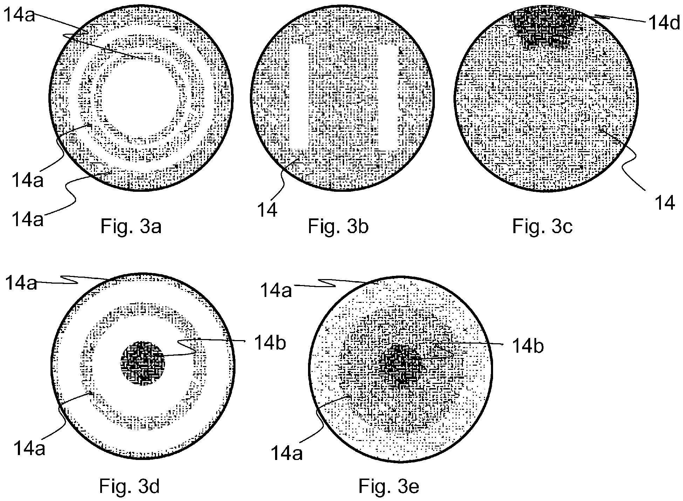

In den Figuren 3a-3e sind weitere lokal definierte Spannungsverteilungen im Werkstück 4 dargestellt. Die bezüglich der Fig. 2a-2f beschriebenen Merkmale und/oder Eigenschaften sind mit den nachfolgend beschriebenen Merkmalen und/oder Eigenschaften der in den Fig. 3a-3d gezeigten Spannungsverteilungen kombinierbar (dies gilt ebenso umgekehrt). Die Werkstückgrundform ist gemäß diesen Figuren rund dargestellt.

In Fig. 3a sind mehrere ringförmige Spannungsverteilungen 14a dargestellt. Es ist hierbei denkbar, dass die Spannungsverteilungen 14a nicht oder nur abschnittsweise ringförmig ausgebildet sind, bevorzugt kann auch abschnittsweise oder vollständig eine spiralförmige Spannungsverteilung induziert werden.

In Fig. 3b ist eine im Wesentlichen flächige bzw. scheibenförmige Spannungsverteilung 14b induziert, wobei die Spannungen im Bereich zweier definierter Abschnitte weniger stark induziert werden. Es ist hierbei denkbar, dass die Spannungen in nur einem Abschnitt weniger stark induziert werden. Weiterhin ist denkbar, dass die Spannungen in einer Vielzahl an Abschnitten weniger stark induziert werden. Die Abschnitte können dabei, wie dargestellt, sich länglich, insbesondere geradlinig, erstrecken oder eine davon abweichende, insbesondere sphärische, Form aufweisen.

In Fig. 3c ist wiederum eine erste Spannungsverteilung 14 und eine weitere Spannungsverteilung 14d induziert. Die weitere Spannungsverteilung 14d ist bevorzugt abschnittsweise ringförmig ausgebildet und erstreckt sich besonders bevorzugt entlang der Außenkante des Werkstücks. Vorzugsweise überlagern die Spannungen 14d, die Spannungen 14 oder vice versa.

In Fig. 3d ist die ringförmige Spannungsverteilung stellenweise weniger stark induziert.

Die Spannungen können bevorzugt je nach Anwendungsgebiet und besonders bevorzugt bei allen Werkstücken am Rand des Werkstücks, in der Mitte des Werkstücks und/oder in einem Bereich zwischen dem Rand bzw. einer Außenkante des Werkstücks und der Mitte bzw. dem Zentrum des Werkstücks induziert werden.

Bevorzugt nimmt die induzierte Spannung ausgehend vom Zentrum des Werkstücks 4 in Richtung Außenkante des Werkstücks 4 ab. Dies ist hierbei durch schmalere Spannungsfelder dargestellt.

In Fig. 3e ist eine Spannungsverteilung dargestellt, deren Intensität von Werkstückrand in Richtung Werkstückzentrum in Stufen zunimmt. Es ist jedoch ebenfalls denkbar, dass die Spannungsintensität kontinuierlich zunimmt, oder dass die Spannungsintensität in Richtung Werkstückzentrum in Stufen oder kontinuierlich abnimmt.

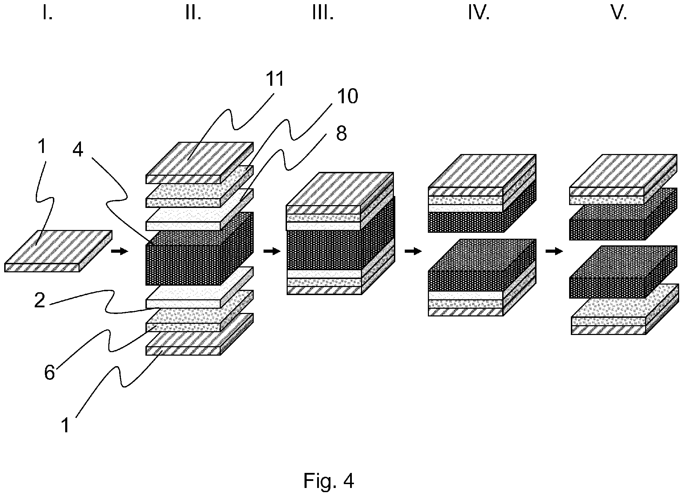

In Fig. 4 ist schematisch die Erzeugung einzelner Festkörperschichten aus einem Werkstück in Form einzelner Siliziumwafer gezeigt, welche unter Einbeziehung einer vordefinierten Spannungsverteilung derart abgespalten werden, dass sich eine gleichmäßige Dickenverteilung des abgespaltenen Wafers ergibt. Die vordefinierte Spannungsverteilung ist bevorzugt direkt oder indirekt, insbesondere mittels Strahlungsquellen, induzierbar. Als Strahlungsquellen können hierbei thermische Strahlungsquellen, wie Heizeinrichtungen oder Kühleinrichtungen, oder sonstige Strahlungseinrichtungen verstanden werden. Es ist ebenfalls denkbar, dass die Spannungsverteilungen durch Wärmeleitung oder Konvektion in das Werkstück induziert werden. Wärmestrahlung, Wärmeleitung oder Konvektion kann bevorzugt durch einzelne oder alle Schichten der Schichtungen 1, 6, 2 oder 8, 10, 11 hindurch bewirkt werden. Zusätzlich oder alternativ ist jedoch auch denkbar, dass die vordefinierte Spannungsverteilung direkt oder indirekt über eine Kraft- bzw. Momentenaufbringung auf eine bzw. mehrere der Schichten 1, 6, 2 oder 8, 10, 11 in das Werkstück einleitbar ist, das heißt, dass die Spannungen besonders bevorzugt durch die Kraft- bzw. Momentenbeaufschlagung auf eine oder mehrere der Stabilisierungsschichten 1, 11 bewirkt wird.

Dabei erfolgt in einem ersten Schritt I die Bereitstellung einer ersten Schicht, insbesondere der Stabilisierungsschicht 1, welche aus Metall und insbesondere aus Aluminium aufgebaut ist. Weiterhin ist denkbar, dass weitere Schichten 2, 4 ebenfalls in diesem Schritt bereit gestellt werden.

In dem zweiten Schritt II werden weitere bisher noch nicht bereitgestellte Schichten erzeugt und/oder mit einander verbunden. Bevorzugt werden die einzelnen Schichten wie dargestellt angeordnet. D.h., dass auf die Stabilisierungsschicht 1 bevorzugt eine Klebeschicht 6 (beispielsweise aus PDMS) aufgebracht wird, um eine Aufnahmeschicht 2 aus PDMS mit der Stabilisierungsschicht 1 zu koppeln bzw. zu verbinden. Die Aufnahmeschicht 2 steht bevorzugt direkt mit einem Werkstück 4 in Kontakt, wobei ebenfalls denkbar ist, dass eine Opferschicht bzw. eine weitere Klebeschicht zwischen der Aufnahmeschicht 2 und dem Werkstück 4 vorsehbar ist.

Der zuvor beschriebene Aufbau mit den Schichten 1, 6, und 2 auf dem Werkstück 4 kann an der anderen Seite des Werkstücks 4 analog aufgebracht werden oder alternativ in veränderter Form aufgebracht werden, wie im Folgenden erläutert ist. Parallel zur Aufnahmeschicht 2 und bevorzugt ebenfalls mit dem Werkstück 4 kontaktierend ist eine Verbindungsschicht 8 insbesondere in Form eines Klebers vorgesehen. Die Verbindungsschicht 8 kann zum Verbinden einer weiteren Aufnahmeschicht 10 aus PDMS und/oder einer weiteren Schicht 11 mit dem Werkstück 4 ausgebildet sein. Die weitere Schicht 11 ist dabei bevorzugt ebenfalls als Stabilisierungsschicht aus Metall oder als ein weiteres Werkstück ausgebildet, wobei an dem weiteren Werkstück wiederum ein entsprechender Schichtaufbau aus den Schichten 1, 6, 2 oder den Schichten 8, 10, 11 vorgesehen sein kann. Die Stabilisierungsschichten 1 sind bevorzugt steif bzw. bestehen aus steifen Materialien und ermöglichen eine mechanische Kopplung mit einer weiteren Einrichtung zur Spannungsbeaufschlagung. Der E-Modul der Stabilisierungsschicht 1 bzw. der Stabilisierungsschichten 1, 11 ist daher höher als der E-Modul der Aufnahmeschichten 2, 10. Zusätzlich oder alternativ ermöglichen die Stabilisierungsschichten 1 eine definierte lokale thermische Beaufschlagung des Werkstücks.

In dem Schritt III werden alle Schichten miteinander verbunden bzw. sind miteinander verbunden.

Im Schritt IV ist das Werkstück 4 in zwei Teile aufgespalten dargestellt, wobei ein Teil davon mit der Schichtanordnung 1, 6, 2 verbunden ist und der andere Teil mit der Schichtanordnung 8, 10, 11 verbunden ist. Beim Übergang vom Schritt III zum Schritt IV werden Spannungen in dem Werkstück 4 erzeugt, durch die das Werkstück 4 in mehrere, insbesondere genau zwei Teile bzw. Festkörperschichten aufgespalten wird. Bevorzugt erfolgt durch die Aufbringung von Kräften auf steiferen Stabilisierungsschicht/en 1, 11 eine mechanische Spannungsinduzierung in den Schichtaufbau. Die Spannungsinduzierung erfolgt aufgrund der beschriebenen Schichtanordnung mit Schichten 1, 6, 2 oder 8, 10, 11 unterschiedlicher E-Modulen äußerst vorteilhaft, da die Schichten mit geringeren E-Modulen beschädigungsfrei am Werkstück 4 anliegen können und die Schichten 1, 11 mit höheren E-Modulen mit weiteren Einrichtungen zur Kraftbeaufschlagung koppelbar sind.

Im optionalen Schritt V werden die einzelnen Festkörperschichten, die aus dem Werkstück 4 gewonnen wurden, wieder von den weiteren Schichten gelöst.

Das erfindungsgemäße Verfahren kann dabei zusätzlich oder alternativ einen oder alle der folgenden Schritte aufweisen: Bereitstellen eines Werkstücks zum Ablösen der Festkörperschichten, wobei das Werkstück zumindest eine exponierte Oberfläche aufweist, Erzeugen und/oder Bereitstellen einer Trägereinheit zum Aufnehmen mindestens einer Festkörperschicht, wobei die Trägereinheit mehrschichtig aufgebaut wird, wobei die Trägereinheit eine Stabilisierungsschicht aufweist und die Stabilisierungsschicht zumindest abschnittsweise durch eine Aufnahmeschicht überlagert wird, wobei die Aufnahmeschicht zum Halten der Festkörperschicht ausgebildet wird, und wobei die Stabilisierungsschicht zumindest abschnittsweise derart ausgebildet wird, dass sie einen E-Modul aufweist, der größer ist als der E-Modul der Aufnahmeschicht, und ein Verbinden der Aufnahmeschicht mit der exponierten Oberfläche des Werkstücks unter Bildung einer Kompositstruktur bzw. eines Laminats, sowie Beaufschlagen der Kompositstruktur mit einem inneren und/oder äußeren Spannungsfeld in der Art, dass die Festkörperschicht entlang einer sich innerhalb des Werkstücks erstreckenden Ebene von dem Werkstück abgelöst wird.

Gemäß einer bevorzugten Ausführungsform der vorliegenden Erfindung bestehen die Aufnahmeschicht und die Stabilisierungsschicht aus unterschiedlichen Materialien, wobei die Aufnahmeschicht bevorzugt ein Polymer, insbesondere Polydimethylsiloxane (PDMS), aufweist und die Stabilisierungsschicht bevorzugt ein Metall, insbesondere Aluminium, umfasst.

Mit der vorliegenden Erfindung, d.h. insbesondere durch die Verwendung von Polymer-Metall-Laminaten als Schichtsysteme zur Erzeugung thermisch induzierter mechanischer Spannungsfelder, werden alle zuvor genannten Probleme und Einschränkungen behoben. Als Werkstück wird in den hier beschriebenen Anwendungsbeispielen vorzugsweise ein dickerer Wafer verwendet, von welchem dann unter Verwendung des beschriebenen Verfahrens ein oder mehrere, dünnere Wafer abgespaltet werden. Diese Ausführungsform ist vorteilhaft, da sie ermöglicht die Dickenschwankungen massiv zu reduzieren, indem statt der nach bisherigem Stand der Technik verwendeten reinen Polymerschichten Schichten aus geeignet konfigurierten Polymer-Metall-Laminaten eingesetzt werden. Diese Schichten bestehen z.B. aus abwechselnd einer Lage aus Polymer und einer Lage aus einem Metall, z.B. Aluminium, wobei die innerste, d.h., die der Waferoberfläche am nächsten liegende, mechanische Spannung erzeugende Schicht bevorzugt jeweils immer aus Polymer besteht. Mit den entsprechenden, im Folgenden beschriebenen erfindungsgemäßen Verfahren können Festkörperschichten, wie insbesondere Wafer, mit viel geringeren totalen Dickenschwankungen hergestellt werden (Wafer mit Dickenschwankungen < 40% der mittleren Waferdicke wurden so bereits experimentell verifiziert), wobei bzgl. räumlicher Dickenverteilung vorteilhaftere lineare Muster erzielt und insbesondere die Bereiche mit den größten Schwankungen eingestellt werden können, wie z.B. in die Nähe des Waferrandes gebracht werden können, wo sie weniger stören.

Bei Anwendungsbeispielen, wo die äußerste (d.h., die am weitesten von der Waferoberfläche entfernte) Schicht des Laminats bevorzugt aus Metall besteht, hat dies infolge der guten Wärmeleitfähigkeit von Metallen außerdem den Vorteil, dass über diese Schicht ein sehr guter thermischer Kontakt zum Laminat möglich ist, was eine effiziente, lokal gut kontrollierbare und reproduzierbare Kühlung des Laminats ermöglicht. Außerdem kann eine Metallschicht oder Metallplatte üblicherweise einfacher an einer Maschine befestigt werden als die verwendeten Polymerschichten, was die automatisierte (Weiter-) Verarbeitung der Wafer erleichtert. Zudem erlaubt eine solche Befestigung, dass mittels einer Maschine, z.B. während des Kühlprozesses, auch externe mechanische Kräfte kontrolliert auf den Verbund Laminat-Wafer ausgeübt werden können, womit der Abspaltprozess weiter beeinflusst werden kann. Insbesondere ist denkbar, dass die Dicke der hergestellten Wafer sowohl durch von außen ausgeübten Kräfte wie auch durch die Steifigkeit (Elastizitätsmodul) der beteiligten Schichten beeinflusst werden kann, und alle diese Parameter sind bei der Verwendung der erfindungsgemäßen Laminate in großen Bereichen gut und weitgehend unabhängig voneinander kontrollierbar. Weiterhin ist es besonders vorteilhaft, dass die Spannungsverteilungen aufgrund der erfindungsgemäßen Laminatstruktur, das heißt der Verwendung zumindest einer Metallschicht, einer Polymerschicht und dem Werkstück, durch die ausgeübten Kräfte und/oder die Steifigkeit der beteiligten Schichten lokal definiert vorgebbar ist, wobei zusätzlich oder alternativ eine inhomogene Temperaturverteilung in dem Werkstück oder den Laminatschichten für die vordefinierte Spannungsverteilung sorgt.

### Bezugszeichenliste

- 1.: Stabilisierungsschicht
- 2.: Aufnahmeschicht
- 4.: Werkstück
- 6.: Klebeschicht
- 8.: Verbindungsschicht
- 10.: Weitere Aufnahmeschicht
- 11.: Weitere Schicht
- 12.: Randbereich
- 13.: Zentrum
- 14.: Definierte Spannungsverteilung
- 14a: ringförmige Spannungsverteilung
- 14b: scheibenförmige Spannungsverteilung
- 14c: linienförmige Spannungsverteilung
- 14d: überlagernde Spannungsverteilung
- 14e: streifenförmige Spannungsverteilung
- 14f: punktförmige Spannungsverteilung
- 20: Fassung
- X: Breite
- Y: Länge
- Z: Dicke

## Patentansprüche

1. Verfahren zur Herstellung von Festkörperschichten, insbesondere zur Verwendung als Wafer, mit den folgenden Schritten:
Bereitstellen eines Werkstücks (4) zum Ablösen der Festkörperschichten,
wobei das Werkstück (4) zumindest eine exponierte Oberfläche aufweist, Erzeugen und/oder Bereitstellen einer Trägereinheit zum Aufnehmen mindestens einer Festkörperschicht, wobei
die Trägereinheit eine Aufnahmeschicht (2) zum Halten der Festkörperschicht aufweist,
Anbringung der Aufnahmeschicht (2) an der exponierten Oberfläche des Werkstücks (4) unter Bildung einer Kompositstruktur,
Erzeugen einer vordefinierten Spannungsverteilung (14) innerhalb des Werkstücks (4) zum Beeinflussen, insbesondere zum definierten Vorgeben, eines Abspaltverlaufs beim Abspalten der Festkörperschicht von dem Werkstück (4) und
Abspalten der Festkörperschicht von dem Werkstück (4) entlang einer sich innerhalb des Werkstücks (4) erstreckenden Ebene gemäß dem durch die vordefinierte Spannungsverteilung (14) beeinflussten Abspaltverlauf,
**dadurch gekennzeichnet, dass**
die Trägereinheit eine Stabilisierungsschicht (1) aufweist und die Stabilisierungsschicht (1) zumindest abschnittsweise durch die Aufnahmeschicht (2) überlagert wird, wobei
sich die thermischen Ausdehnungskoeffizienten des Materials der Stabilisierungsschicht (1) und des Materials der Aufnahmeschicht (2) zumindest um den Faktor 2 unterscheiden, wobei der thermische Expansionskoeffizient der Stabilisierungsschicht (1) kleiner ist als der thermische Expansionskoeffizient der Aufnahmeschicht (2).

2. Verfahren nach Anspruch 1,
**dadurch gekennzeichnet, dass**
die Geometrie der Stabilisierungsschicht (1) und/oder der Aufnahmeschicht (2) derart gewählt ist, dass sie zumindest abschnittsweise die Spannungsverteilung (14) beeinflusst, insbesondere vorgibt.

3. Verfahren nach einem der vorhergehenden Ansprüche,
**dadurch gekennzeichnet, dass**
die vorgegebenen Spannungsverteilung (14) durch die Aufbringung mechanischer, elektrischer und/oder magnetischer Kräfte auf die Kompositstruktur beeinflusst, insbesondere vorgegeben, wird.

4. Verfahren nach einem der vorhergehenden Ansprüche 1 bis 3,
**dadurch gekennzeichnet, dass**
die vorgegebenen Spannungsverteilung (14) durch eine Temperierung der Stabilisierungsschicht (1) und/oder der Aufnahmeschicht (2) beeinflusst, insbesondere vorgegeben, wird, wobei die Stabilisierungsschicht (1) und/oder die Aufnahmeschicht (2) jeweils lokal unterschiedlich temperiert werden und/oder lokal jeweils unterschiedliche Temperarturverläufe aufweisen.

5. Verfahren nach einem der vorangegangenen Ansprüche 1 bis 4,
**dadurch gekennzeichnet, dass**
die Aufnahmeschicht (2) und die Stabilisierungsschicht (1) aus unterschiedlichen Materialien bestehen, wobei die Aufnahmeschicht (2) bevorzugt ein Polymer, insbesondere Polydimethylsiloxane (PDMS), aufweist und die Stabilisierungsschicht (1) bevorzugt ein Metall aufweist.

6. Verfahren nach einem der vorangegangenen Ansprüche 1 bis 5,
**dadurch gekennzeichnet, dass**
die Aufnahmeschicht (2) als Folie erzeugt wird und die Aufnahmeschicht (2) zur Ausbildung der Trägereinheit mit der Stabilisierungsschicht (1) stoffschlüssig verbunden wird, wobei die Aufnahmeschicht (2) insbesondere mittels einer Klebeschicht (6), plasmaaktiviertem Kleben oder Auflaminieren mit der Stabilisierungsschicht (1) verbunden wird.

7. Verfahren nach einem der Ansprüche 1 bis 6,
**dadurch gekennzeichnet, dass**
die Aufnahmeschicht (2) strukturiert ist und die Aufnahmeschicht (2) durch die Aufbringung eines zumindest zeitweise fließfähigen Materials auf die Stabilisierungsschicht (1) und eine Verfestigung des Materials ausgebildet wird.

8. Verfahren nach Anspruch 7,
**dadurch gekennzeichnet, dass**
das Werkstück (4) vor der Verfestigung des Materials mit dem Material in Kontakt gebracht wird, wobei das Werkstück (4) zumindest abschnittsweise in das Material eintaucht, wobei die Eintauchtiefe einstellbar ist, insbesondere mittels einer Erhöhung der vom Werkstück (4) auf die Trägereinheit ausgeübten Normalkraft oder durch die Einbringung von Abstandshaltern.

9. Verfahren nach einem der vorhergehenden Ansprüche,
**dadurch gekennzeichnet, dass**
eine Verbindungsschicht (8), insbesondere ein Polymer und bevorzugt Polydimethylsiloxane (PDMS) aufweisend, auf das Werkstück (4) aufgebracht wird, wobei die Verbindungsschicht (8) im Wesentlichen parallel zur Aufnahmeschicht (2) angeordnet ist und die im Wesentlichen zueinander parallelen Anteile der Verbindungsschicht (8) und der Aufnahmeschicht (2) durch das sich dazwischen erstreckende Werkstück (4) voneinander beabstandet sind.

10. Verfahren nach einem der vorangegangenen Ansprüche 1 bis 9,
**dadurch gekennzeichnet, dass**
die Stabilisierungsschicht (1) und die Aufnahmeschicht (2) derart miteinander verbunden werden, dass definierte Spannungen (14) zwischen diesen Schichten (1, 2) übertragen werden.

11. Verfahren nach einem der vorangegangenen Ansprüche,
**dadurch gekennzeichnet, dass**
die Aufnahmeschicht ein Polymer aufweist, wobei beim Beaufschlagen der Kompositstruktur aus Aufnahmeschicht und Werkstück mit einem inneren und/oder äußeren Spannungsfeld mindestens ein Teil des Polymers durch mindestens einen Glasübergang geht.

12. Vorrichtung zum Herstellen von Festkörperschichten, insbesondere von Wafern, mindestens umfassend
eine Beaufschlagungseinrichtung zum Beaufschlagen des Werkstücks (4) mit Spannungen zum Abspalten einer Festkörperschicht und
eine Trägereinheit gemäß Anspruch 13.

13. Trägereinheit zum Aufnehmen mindestens einer Festkörperschicht, wobei die Trägereinheit
eine Stabilisierungsschicht (1) aufweist und die Stabilisierungsschicht (1) zumindest abschnittsweise durch eine Aufnahmeschicht (2) überlagert ist, wobei
die Aufnahmeschicht (2) zum Halten der Festkörperschicht ausgebildet ist, und wobei
die Stabilisierungsschicht (1) zumindest abschnittsweise derart ausgebildet wird, dass sie einen thermischen Ausdehnungskoeffizienten aufweist, der kleiner ist als der thermische Ausdehnungskoeffizient der Aufnahmeschicht (2).

## Claims

1. A method of manufacturing a solid layer, especially for use as a wafer, with the following steps:
preparation of a workpiece (4) for detachment from the solid layer, wherein the workpiece (4) at least comprises an exposed upper surface,
production and/or preparation of a carrier unit for bearing at least one solid layer, wherein the carrier unit comprises a carrier layer (2) for holding the solid layer,
attachment of the carrier layer (2) to the exposed upper surface of the workpiece (4) to form a composite structure,
production of a predefined stress distribution (14) inside the workpiece (4) for the influencing, especially in a predefined manner, of a detachment process with detachment of the solid layer from the workpiece (4), and
detachment of the solid layer from the workpiece (4) along a plane extending inside the workpiece (4) according to the detachment process influenced by the predefined stress distribution (14),
**characterized in that**:
the carrier unit comprises a stabilising layer (1) and the stabilising layer (1) is overlaid at least in a cross-sectional direction by the carrier layer (2), wherein
the coefficient of thermal expansion of the material of the stabilising layer (1) and of the material of the carrier layer (2) differ from each other by a factor of at least 2, wherein the coefficient of thermal expansion of the stabilising layer (1) is smaller than the coefficient of thermal expansion of the carrier layer (2).

2. A method according to claim 1, **characterized in that** the geometry of the stabilising layer (1) and/or of the carrier layer (2) is chosen such that it applies, especially predefines, the stress distribution (14) at least in a cross-sectional direction.

3. A method according to any one of the preceding claims, **characterized in that** the predefined stress distribution (14) is applied by the application of mechanical, electrical and/or magnetic forces, in particular those which are predefined, to the composite structure.

4. A method according to any one of claims 1 to 3, **characterized in that** the predefined stress distribution (14) is applied, especially predefined, by tempering of the stabilising layer (1) and/or of the carrier layer (2), wherein the stabilising layer (1) and/or the carrier layer (2) are each locally differently tempered and/or locally each comprise different temperature gradients.

5. A method according to any one of claims 1 to 4, **characterized in that** the carrier layer (2) and the stabilising layer (1) are made of different materials, wherein the carrier layer (2) preferably comprises a polymer, especially polydimethylsiloxane (PDMS), and the stabilising layer (1) preferably comprises a metal.

6. A method according to any one of claims 1 to 5, **characterized in that** the carrier layer (2) is generated as a foil and the carrier layer (2) is bonded cohesively to the stabilising layer (1) to create the carrier unit, wherein the carrier layer (2) is bonded to the stabilising layer (1), especially by means of an adhesive layer (6), a plasma-activated adhesive or by lamination thereon.

7. A method according to any one of claims 1 to 6, **characterized in that** the carrier layer (2) is structured, and the carrier layer (2) is adapted by the application of an at least temporarily flowing material onto the stabilising layer (1) and bonding of the material thereto.

8. A method according to claim 7, **characterized in that** the workpiece (4) is brought into contact with the material before the bonding of the material, wherein the workpiece (4) is dipped into the material at least in a cross-sectional direction, wherein the dipping depth is adjustable, especially by means of a raising of the workpiece (4) on the carrier unit exercising normal power or by a reduction in their separation.

9. A method according to any one of the preceding claims, **characterized in that** a bonding layer (8), especially comprising a polymer and preferably polydimethylsiloxane (PDMS), is applied to the workpiece (4), wherein the bonding layer (8) is arranged substantially parallel to the carrier layer (2) and the bonding layer (8) and the carrier layer (2), which are in substantially parallel alignment with each other, are separated from each other by the workpiece (4) extending therebetween.

10. A method according to any one of claims 1 to 9, **characterized in that** the stabilising layer (1) and the carrier layer (2) are bonded together such that the defined stress distribution (14) is transmitted between these layers (1, 2).

11. A method according to any one of the preceding claims, **characterized in that** the carrier layer comprises a polymer, wherein upon application to the composite structure of the carrier layer and workpiece of an external and/or internal electric field, at least a part of the polymer goes through at least one glass transition.

12. An apparatus for the manufacture of a solid layer, especially of a wafer, at least comprising:
an application device for application to the workpiece (4) of a stress distribution to separate a solid layer therefrom, and
a carrier unit according to claim 13.

13. A carrier unit for bearing at least one solid layer, wherein the carrier unit comprises:
a stabilising layer (1) and the stabilising layer (1) is overlaid at least in a cross-sectional direction by a carrier layer (2), wherein
the carrier layer (2) is adapted to hold the solid layer, and wherein
the stabilising layer (1) is adapted at least in a cross-sectional direction such that it provides a coefficient of thermal expansion which is less than the coefficient of thermal expansion of the carrier layer (2).

## Revendications

1. Procédé de production de couches de corps solide, en particulier pour l'utilisation en tant que plaquette, avec les étapes suivantes :
mise à disposition d'une pièce (4) pour détacher les couches de corps solides,
dans lequel la pièce (4) présente au moins une surface exposée,
génération et/ou mise à disposition d'une unité porteuse pour la réception d'au moins une couche de corps solide, dans lequel
l'unité porteuse présente une couche de réception (2) pour maintenir la couche de corps solide,
pose de la couche de réception (2) au niveau de la surface exposée de la pièce (4) en formant une structure composite,
génération d'une distribution de contraintes prédéfinie (14) à l'intérieur de la pièce (4) pour influencer, en particulier pour prescrire de façon définie, un déroulement de séparation lors de la séparation de la couche de corps fixe de la pièce (4) et
séparation de la couche de corps fixe de la pièce (4) le long d'un plan s'étendant à l'intérieur de la pièce (4) conformément au déroulement de séparation influencé par la distribution de contraintes prédéfinie (14),
**caractérisé en ce que**
l'unité porteuse présente une couche de stabilisation (1) et la couche de stabilisation (1) est couverte au moins par section par la couche de réception (2), dans lequel
les coefficients de dilatation thermique du matériau de la couche de stabilisation (1) et du matériau de la couche de réception (2) se distinguent au moins du facteur 2, dans lequel le coefficient d'expansion thermique de la couche de stabilisation (1) est inférieur au coefficient d'expansion thermique de la couche de réception (2).

2. Procédé selon la revendication 1,
**caractérisé en ce que**
la géométrie de la couche de stabilisation (1) et/ou de la couche de réception (2) est sélectionnée de telle sorte qu'elle influence, en particulier prescrit, au moins par section la distribution des contraintes (14).

3. Procédé selon l'une quelconque des revendications précédentes,
**caractérisé en ce que**
la distribution des contraintes (14) prescrite est influencée, en particulier prescrite, par l'application de forces mécaniques, électriques et/ou magnétiques sur la structure composite.

4. Procédé selon l'une quelconque des revendications précédentes 1 à 3,
**caractérisé en ce que**
la distribution de contraintes (14) prescrite est influencée, en particulier prescrite, par la mise à température de la couche de stabilisation (1) et/ou de la couche de réception (2), dans lequel la couche de stabilisation (1) et/ou la couche de réception (2) sont mises à température respectivement localement de manière différente et/ou présentent localement respectivement des courbes de température différentes.

5. Procédé selon l'une quelconque des revendications précédentes 1 à 4,
**caractérisé en ce que**
la couche de réception (2) et la couche de stabilisation (1) se composent de différents matériaux, dans lequel la couche de réception (2) présente de préférence un polymère, en particulier du polydiméthylsiloxane (PDMS), et la couche de stabilisation (1) présente de préférence un métal.

6. Procédé selon l'une quelconque des revendications précédentes 1 à 5,
**caractérisé en ce que**
la couche de réception (2) est générée en tant que film et la couche de réception (2) est reliée par correspondance de substance à la couche de stabilisation (1) pour la réalisation de l'unité porteuse, dans lequel la couche de réception (2) est reliée à la couche de stabilisation (1) en particulier au moyen d'une couche d'adhésif (6), par collage activé par plasma ou stratification.

7. Procédé selon l'une quelconque des revendications précédentes 1 à 6,
**caractérisé en ce que**
la couche de réception (2) est structurée et la couche de réception (2) est réalisée par l'application d'un matériau au moins temporairement fluide sur la couche de stabilisation (1) et une solidification du matériau.

8. Procédé selon la revendication 7,
**caractérisé en ce que**
la pièce (4) est mise en contact avec le matériau avant la solidification du matériau, dans lequel la pièce (4) plonge au moins par section dans le matériau, dans lequel la profondeur de plongée est réglable, en particulier au moyen d'une augmentation de la force normale exercée par la pièce (4) sur l'unité porteuse ou par l'introduction d'écarteurs.

9. Procédé selon l'une quelconque des revendications précédentes,
**caractérisé en ce que**
une couche de liaison (8), présentant en particulier un polymère et de préférence du polydiméthylsiloxane (PDMS), est appliquée sur la pièce (4), dans lequel la couche de liaison (8) est agencée de manière sensiblement parallèle à la couche de réception (2) et les parts sensiblement parallèles l'une à l'autre de la couche de liaison (8) et de la couche de réception (2) sont espacées l'une de l'autre par la pièce (4) s'étendant entre elles.

10. Procédé selon l'une quelconque des revendications précédentes 1 à 9,
**caractérisé en ce que**
la couche de stabilisation (1) et la couche de réception (2) sont reliées l'une à l'autre de telle sorte que des contraintes définies (14) sont transmises entre ces couches (1, 2).

11. Procédé selon l'une quelconque des revendications précédentes,
**caractérisé en ce que**
la couche de réception présente un polymère, dans lequel lors de la sollicitation de la structure composite formée de la couche de réception et de la pièce avec un champ de contraintes intérieur et/ou extérieur, au moins une partie du polymère passe par au moins un passage de verre.

12. Dispositif de production de couches de corps solide, en particulier de plaquettes, comprenant au moins
un dispositif de sollicitation pour la sollicitation de la pièce (4) avec des contraintes pour séparer une couche de corps solide et
une unité porteuse selon la revendication 13.

13. Unité porteuse pour la réception d'au moins une couche de corps solide, dans laquelle l'unité porteuse présente une couche de stabilisation (1) et la couche de stabilisation (1) est couverte au moins par section par une couche de réception (2), dans laquelle
la couche de réception (2) est réalisée pour maintenir la couche de corps solide, et dans laquelle
la couche de stabilisation (1) est réalisée au moins par section de telle sorte qu'elle présente un coefficient de dilatation thermique, qui est inférieur au coefficient de dilatation thermique de la couche de réception (2).
